# EUROPÄISCHE PATENTSCHRIFT

(11) **EP 1 458 025 B1**
(45) Veröffentlichungstag und Bekanntmachung des Hinweises auf die Patenterteilung: **03.06.2009**
(21) Anmeldenummer: 03027229.8
(22) Anmeldetag: 28.11.2003
(51) Int. Cl.: H01L 27/02

(54) **Integrierte Schaltungen mit getrennter Spannungsversorgung**
Integrated circuits having separate power supply lines
Circuits intégrés à lignes d'alimentation électrique séparées

(30) Priorität: 17.01.2003 DE 10301586
(43) Veröffentlichungstag der Anmeldung: 15.09.2004
(73) Patentinhaber: Micronas GmbH, 79108 Freiburg i. Br. (DE)
(72) Erfinder: Czech, Martin, 79117 Freiburg (DE); Reinhard, Erwe, 79104 Freiburg (DE)
(74) Vertreter: Patentanwälte Westphal, Mussgnug & Partner

(56) Entgegenhaltungen:
- JP-A- 10 290 519
- US-A- 6 011 681
- US-B1- 6 271 999

## Beschreibung

Die vorliegende Erfindung betrifft eine integrierte Schaltung mit wenigstens zwei Schaltungsteilen, die auf einem gemeinsamen Halbleitersubstrat gebildet sind und jeweils über eigene Versorgungsspannungsnetze verfügen, die jeweils eigene Bondflecken zum Einspeisen einer von außen zugeführten Versorgungsspannung aufweisen. Derartige getrennte Versorgungsspannungsnetze können z.B. aus EMV-Gründen erforderlich sein. Bei den üblichen Technologien für hochintegrierte Schaltungen ist das Halbleitersubstrat p-leitend und mit Versorgungsknoten der zwei Schaltungsteile, die das niedrigste Potential "Vss" unter den angelegten Potentialen führen, durch Substratkontakte verbunden, so dass die Vss-Potentiale der zwei Schaltungsteile durch einen Substratwiderstand verkoppelt sind.

Meist wird es eine oder mehrere Verbindungen in Form von Signalleitungen zwischen zwei Schaltungsteilen geben. Die an sich gewünschte Trennung der Versorgungsspannungsnetze der einzelnen Schaltungsteile kann zu Problemen bei Überspannungen (EOS, Electrical Overstress), insbesondere bei statischen Entladungen (ESD, Electrostatic Discharge) führen, da die Versorgungsspannungsnetze der einzelnen Schaltungsteile kleiner an Fläche sind und eine geringere Zahl von Bauelementen versorgen als ein entsprechendes, die gesamte integrierte Schaltung erfassendes Netz und sie daher empfindlicher auf Schaltvorgänge einzelner Bauelemente reagieren, und Differenzspannungen von einem Schaltungsteil zum anderen über die Signalleitungen übertragen werden und empfindliche Schaltungsteile wie z.B. Gate-Oxid-Schichten erreichen können, die durch diese Spannungen zerstört werden können.

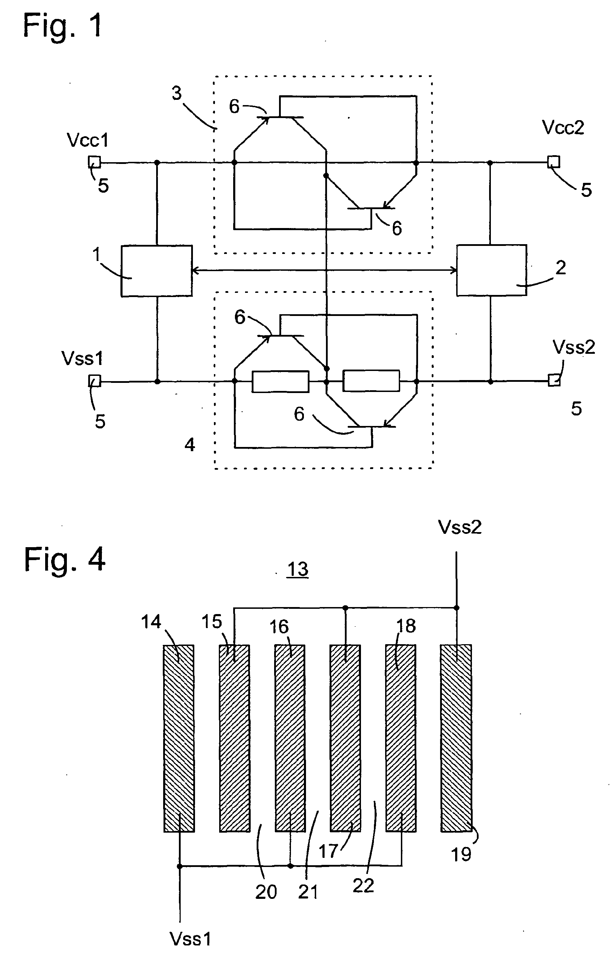

Es ist daher Stand der Technik, die Versorgungsspannungsnetze mehrerer auf einem gemeinsamen Halbleitersubstrat integrierter Schaltungsteile durch Koppelschaltungen wie in Fig. 1 dargestellt zu verkoppeln. Fig. 1 zeigt schematisch eine integrierte Schaltung mit Schaltungsteilen 1, 2, die mit Versorgungspotentialen Vcc1, Vss1 bzw. Vcc2, Vss2 über Bondflecken 5 versorgt werden, wobei unter normalen Betriebsbedingungen Vcc1=Vcc2 und Vss1=Vss2 gilt. Koppelschaltungen 3, 4 zwischen den Versorgungspotentialen Vcc1 und Vcc2 bzw. Vss1 und Vss2 sind jeweils durch antiparallele Schaltungen von zwei pnp-Transistoren 6 gebildet. Wenn eine Überspannung die Versorgungsspannungsnetze der Schaltungsteile 1, 2 gegeneinander verzieht, so erfolgt ein Spannungsausgleich über die Transistoren 6, wobei ein Teil des Stroms vom Emitter zur Basis und der Rest weiter zum Kollektor weiter fließt.

Die pnp-Transistoren 6 haben jeweils das Halbleitersubstrat als Kollektor, eine in dem Substrat gebildete, n-dotierte Wanne als Basis und ein p⁺-Gebiet innerhalb der Wanne als Emitter. Ein solcher Aufbau bewirkt, dass wenn bei einer Überspannung einer der Transistoren 6 eine der Koppelschaltungen 3 oder 4 öffnet, zwar ein Teil des Ausgleichsstroms (vom Emitter zur Basis) von einem Versorgungsnetz in das andere fließen wird, unausweichlich jedoch auch ein Teil direkt vom Emitter in das Substrat, das den Kollektor darstellt.

Diese herkömmlichen Koppelschaltungen belegen eine erhebliche Substratfläche, zum einen weil von den Koppelschaltungen, von denen pro auszugleichende Versorgungsspannung jeweils eine benötigt wird, jede zwei Transistoren 6 aufweist, zum anderen, weil am Stromfluss durch die Transistoren 6 im wesentlichen Löcher beteiligt sind, deren Beweglichkeit geringer ist als die von Elektronen und die daher bei vorgegebenen Dotierungskonzentrationen vergleichsweise große Flächenausdehnungen der Dotierungszonen benötigen, um einen für eine wirksame Kopplung ausreichenden niedrigen Durchgangswiderstand der Transistoren zu erzielen.

JP-10-290519 A offenbart eine integrierte Schaltung mit zwei Schaltungsteilen mit unterschiedlichen Versorgungsspannungsnetzen und mit einer Koppelschaltung, wobei der Kollektor eines bipolaren Transistors direkt mit dem Potential eines ersten Schaltungsteils und der Emitter direkt mit dem Potential eines zweiten Schaltungsteils verbunden ist.

Aufgabe der Erfindung ist, eine integrierte Schaltung mit wenigstens zwei Schaltungsteilen und getrennten Versorgungsspannungsnetzen für die verschiedenen Schaltungsteile anzugeben, die eine einfach strukturierte Koppelschaltung mit geringem Flächenbedarf zwischen den Versorgungsspannungsnetzen aufweist.

Die Aufgabe wird gelöst durch eine integrierte Schaltung mit den Merkmalen des Anspruchs 1.

Vorzugsweise ist bei einer solchen Schaltung die Basis des Transistors durch das Substrat selbst, genauer gesagt durch eine an Kollektor- und Emitter-Dotierungszonen des Transistors angrenzende Region des Substrats gebildet, und der Widerstand zwischen der Basis und den durch die Koppelschaltung gekoppelten Potentialen der zwei Netze ist der intrinsische Widerstand des Substrats zwischen dessen die Basis bildenden Region und jeweils einer Kontaktdotierungszone, die mit dem Kollektor bzw. dem Emitter durch eine auf das Substrat aufgebrachte Metallisierung leitend verbunden ist.

Um ein identisches Koppelverhalten des Transistors in beide Richtungen zu erzielen, sind dessen Kollektor und Emitter vorzugsweise völlig symmetrisch aufgebaut, so dass man auch von einem Transistor mit doppelten Emitter sprechen könnte.

Im Prinzip kann die Koppelschaltung gemäß der Erfindung mit einem einzigen Transistor realisiert werden, dessen Abmessungen festgelegt sind durch den gewünschten Durchgangswiderstand. Eine größere Gestaltungsfreiheit hinsichtlich der Unterbringung der Koppelschaltung auf einer Substratoberfläche ohne erhöhten Flächenbedarf ergibt sich jedoch bei Verwendung mehrerer Transistoren. Diese können grundsätzlich unabhängig voneinander auf der Substratoberfläche verteilt werden.

Eine besonders platzsparende Ausgestaltung resultiert, wenn die Transistoren durch eine Mehrzahl von Dotierungszonen des zweiten Leitfähigkeitstyps gebildet sind, die abwechselnd mit dem einen und dem anderen der zwei Versorgungspotentiale verbunden sind. Wenn nämlich eine mit dem Versorgungspotential des ersten Schaltungsteils verbundene Dotierungszone an zwei Seiten - jeweils mit einer dazwischenliegenden, die natürliche Dotierung des Substrats aufweisenden Basiszone - von mit dem Versorgungspotential des zweiten Schaltungsteils verbundenen Dotierungszonen umgeben ist, so entspricht eine solche Anordnung zwei parallelen Transistoren. Der Oberflächenbedarf für zwei Transistoren ist bei einer solchen Anordnung also deutlich weniger als das Doppelte des Platzbedarfs von zwei Einzeltransistoren, und die Platzersparnis lässt sich noch steigern, wenn mehr als zwei Transistoren durch eine entsprechende alternierende Anordnung von mit den zwei Versorgungspotentialen verbundenen Dotierungszonen gebildet werden.

Um ein identisches Verhalten aller dieser Transistoren zu erreichen, sollten deren Dotierungszonen zweckmäßigerweise in einer Reihe äquidistant angeordnet sein.

Die Kontaktdotierungszonen sind vorzugsweise an den Enden der Reihe angeordnet. Es genügen somit zwei Kontaktdotierungszonen für eine Mehrzahl von Transistoren, wodurch sich wiederum eine Flächeneinsparung ergibt.

Vorzugsweise ist bei einer solchen Reihenanordnung von Kontaktdotierungszonen und von Emitter bildenden Dotierungszonen jede einen Emitter bildende Dotierungszone, die einer Kontaktdotierungszone unmittelbar benachbart ist, mit dieser metallisch leitend verbunden. Diese Anordnung reduziert im Falle eines Überspannungsimpulses die Gefahr eines Durchschlags von einer mit dem ersten Schaltungsteil verbundenen Kontaktdotierungszone zu einer mit dem zweiten Schaltungsteil verbundenen einen Emitter bildenden Dotierungszone.

Um eine möglichst perfekte Symmetrie der Koppelschaltung und damit ein gleiches Koppelverhalten in beiden Richtungen zu erzielen, muss die Zahl der die Emitter bildenden Dotierungszonen des zweiten Leitfähigkeitstyps gerade sein. Vorzugsweise beträgt diese Zahl der Dotierungszonen 4, was einer Parallelschaltung von drei Transistoren entspricht.

Um eine unerwünscht starke Wechselwirkung zwischen den Transistoren der Koppelschaltung und den Schaltungsteilen zu vermeiden, ist es zweckmäßig, wenn der wenigstens eine Transistor der Koppelschaltung von einer Abschirmdotierungszone des zweiten Leitfähigkeitstyps umgeben ist. Eine solche Abschirmdotierungszone ist zweckmäßigerweise in Sperrrichtung vorgespannt, so dass sich zwischen ihr und dem Substrat eine Sperrschicht ausbildet.

Vorzugsweise verläuft die Abschirmdotierungszone ringförmig entlang der Oberfläche des Substrats. Sie unterbindet somit nicht jeglichen Stromfluss von dem wenigstens einen Transistor der Koppelschaltung durch das Substrat zu den Schaltungsteilen, sondern sie zwingt die Ladungsträger zu einem Umweg in die Tiefe des Substrats, wodurch sich deren Weg und damit der effektive Widerstand des Substrats zwischen den Transistoren der Koppelschaltung und den Schaltungsteilen erhöht.

Die Kontaktdotierungszonen der Koppelschaltung sind vorzugsweise von der Abschirmdotierungszone umgeben.

Weitere Merkmale und Vorteile der Erfindung ergeben sich aus der nachfolgenden Beschreibung von Ausführungsbeispielen unter Bezugnahme auf die beigefügten Figuren. Es zeigen:
- Fig. 1: bereits behandelt,
ein schematisches Schaltbild einer integrierten Schaltung mit über jeweils eigene Versorgungsspannungsnetze verfügenden Schaltungsteilen nach dem Stand der Technik;
- Fig. 2: ein schematisches Schaltbild einer Koppelschaltung gemäß der vorliegenden Erfindung;
- Fig. 3: die Strom-Spannungs-Kennlinie der Koppelschaltung aus Fig. 2;
- Fig. 4: ein Beispiel für eine Oberflächenstruktur einer Koppelschaltung gemäß der vorliegenden Erfindung;
- Fig. 5: ein Ersatzschaltbild der Oberflächenstruktur aus Fig. 4;
- Fig. 6: eine Abwandlung der Oberflächenstruktur aus Fig. 4;
- Fig. 7: eine Weiterentwicklung der Oberflächenstruktur aus Fig. 6 und
- Fig. 8: einen Schnitt durch die Struktur der Fig. 7 der Oberflächenstruktur aus Fig. 6;
- Fig. 9: eine zweite Weiterentwicklung der Oberflächenstruktur.

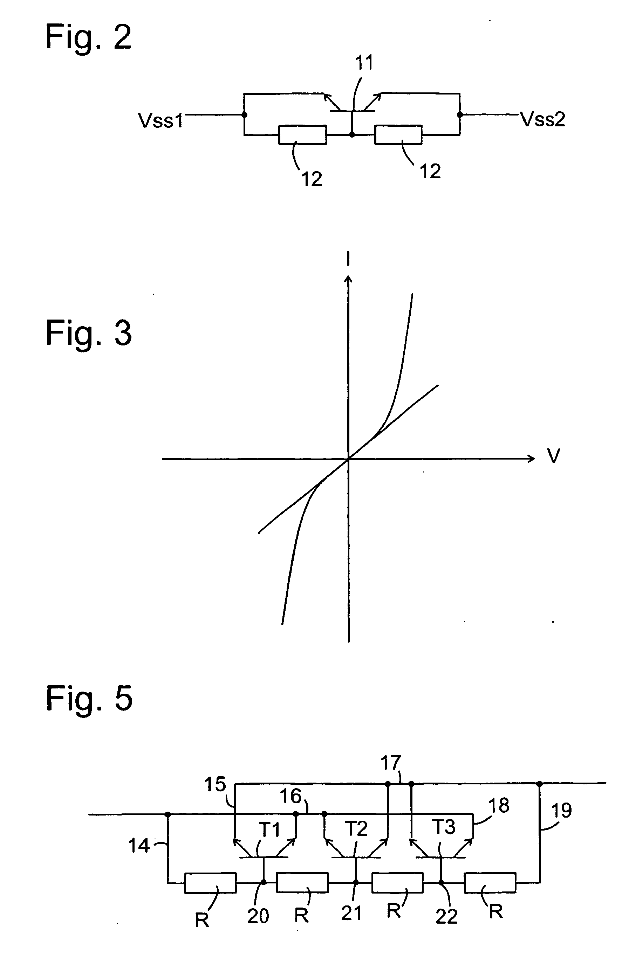

Die in Fig. 2 gezeigte Koppelschaltung ist vorgesehen, um die herkömmliche Koppelschaltung 4 der integrierten Schaltung aus Fig. 1 zu ersetzen. Ein npn-Transistor 11, dessen Geometrie und Dotierungen völlig symmetrisch sind und der deshalb mit zwei Emittern dargestellt ist, ist über den einen Emitter mit Vss1 und über den anderen mit Vss2 verbunden. Die beiden Versorgungspotentiale Vss1, Vss2 sind jeweils über identische Widerstände 12 mit der Basis des Transistors 11 verbunden.

Fig. 3 zeigt die Strom-Spannungskennlinie der Koppelschaltung aus Fig. 2. Bei kleinen Differenzen zwischen den zwei Versorgungspotentialen ist das Verhalten rein resistiv und durch die Widerstände 12 bestimmt; bei zunehmenden Spannungen setzt die Aktivität des Transistors 11 ein, und der durch die Koppelschaltung fließende Ausgleichsstrom I nimmt mehr als linear mit der Spannung V zu.

Fig. 4 zeigt ein erstes Beispiel für ein praktisches Layout einer Koppelschaltung gemäß der Erfindung. Auf einem p⁻-dotierten Halbleitersubstrat sind in einer Reihe nebeneinanderliegend sechs Dotierungszonen 14 bis19 gebildet, von denen die zwei zuäußerst liegenden p⁺-dotiert sind und als Kontaktdotierungszonen 14, 19 bezeichnet werden und die dazwischen liegenden sog. Emitterdotierungszonen 15 bis 18 n⁺-dotiert sind. Oberflächenmetallisierungen der Dotierungszonen 14, 16, 18 sind mit Vss1, solche der Dotierungszonen 15, 17, 19 mit Vss2 verbunden. Zwischen den Emitterdotierungszonen 15 bis 18 liegende Oberflächenstreifen 20, 21, 22 des Substrats 13 weisen dessen ursprüngliche p⁻-Dotierung in nicht durch die Erzeugung der Dotierungszonen 14 bis 19 veränderter Dotierungskonzentration auf. Diese Oberflächenstreifen 20, 21 oder 22 fungieren jeweils als Basis eines symmetrischen Transistors, dessen zwei Emitter durch die. zwei an den betreffenden Oberflächenstreifen 20 angrenzenden Emitterdotierungszonen gebildet sind. Im Falle einer Spannungsdifferenz zwischen Vss1 und Vss2 ermöglichen die Kontaktdotierungszonen 14, 19 einen Stromfluss durch das Substrat 13 von einer Kontaktdotierungszone 14, 19 zur anderen. Dieser Stromfluss bestimmt die jeweils im Bereich der einzelnen Oberflächenstreifen 20, 21, 22 wirksamen elektrischen Potentiale. Dem Layout der Fig. 4 entspricht daher das in Fig. 5 gezeigte Ersatzschaltbild. Hier erkennt man deutlich, dass die zwei mittleren Emitterdotierungszonen 16, 17 des Layouts aus Fig. 4 jeweils Emittern von zwei symmetrischen npn-Transistoren T1, T2 bzw. T2, T3 entsprechen, deren Basen jeweils durch die Oberflächenstreifen 20, 21, 22 gebildet sind. Widerstände R zwischen der Kontaktdotierungszone 14, den Basen der Transistoren und der Kontaktdotierungszone 19 resultieren aus der geringen intrinsischen Leitfähigkeit des schwach dotierten Substrats 13.

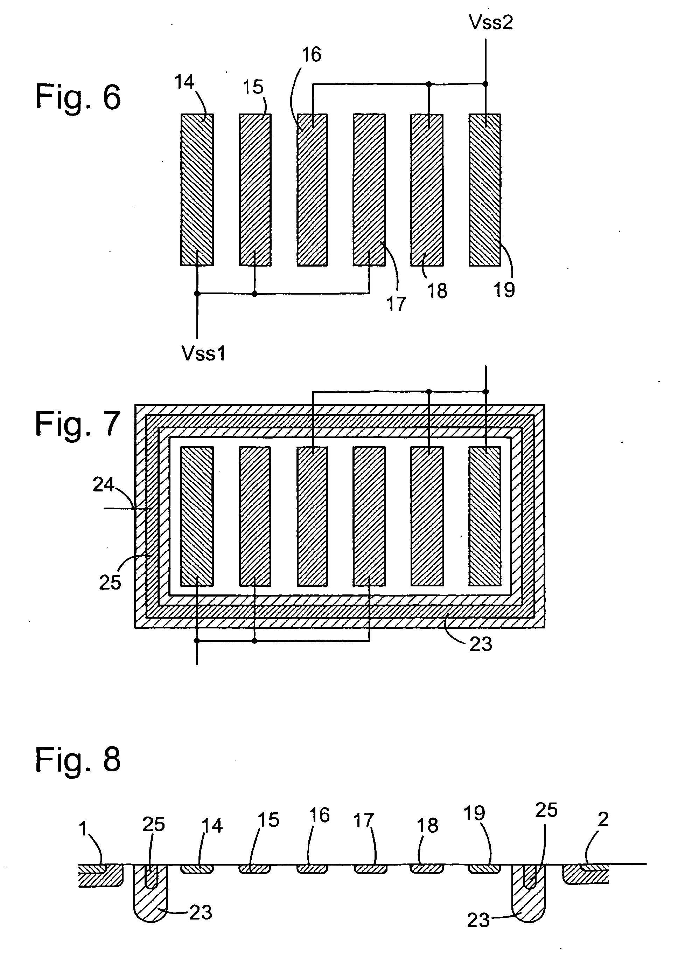

Fig. 6 zeigt eine zweite Ausgestaltung eines Layouts einer Koppelschaltung. Sie unterscheidet sich von dem in Fig. 4 gezeigten Layout dadurch, dass die mit Vss1 bzw. Vss2 verbundenen Emitterzonen vertauscht sind, so dass die jeweils benachbarten Dotierungszonen 14 und 15 bzw. 18 und 19 jeweils über eine Metallisierung parallelgeschaltet sind. Da auf diese Weise der Abstand zwischen den Kontaktimplantationszonen 14 bzw. 19 und den nächst benachbarten, mit der jeweils anderen Versorgungsspannung verbundenen Emitterdotierungszonen 16, 17 gegenüber dem Layout aus Fig. 4 vergrößert ist und entsprechend auch der Substratwiderstand entsprechend vergrößert ist, ist die Gefahr, dass ein Überspannungsimpuls einen Durchbruch an einer pn-Grenzschicht der Emitterdotierungszonen hervorruft, verringert. D.h., die Spannungsfestigkeit ist bei gleichbleibenden Dimensionierung und Anordnung der Dotierungszonen gegenüber dem Layout aus Fig. 4 verbessert, oder die Breite der Oberflächenstreifen zwischen den Kontaktdotierungszonen 14, 19 und den ihnen benachbarten Emitterdotierungszonen 15 bzw. 18 kann bei gleichbleibender Spannungsfestigkeit vermindert werden, wodurch sich der Platzbedarf der Koppelschaltung weiter verringert.

Fig. 7 zeigt eine weiterentwickelte Ausgestaltung des Layouts aus Fig. 6. Da die durch die Oberflächenstreifen 20 bis 22 und die ihnen benachbarten Emitterdotierungszonen 15 bis 18 gebildeten Transistoren unvermeidlich mit dem Substrat 13 verkoppelt sind, wird zur Verringerung von Wechselwirkungen zwischen den Transistoren der Koppelschaltung und den Elementen der Schaltungsteile 1, 2 eine Abschirmdotierungszone 23 vorgesehen, die durch n-Dotierung mit hoher Eindringtiefe in das Substrat 13 gebildet ist. Die Abschirmdotierungszone 23 ist an der Oberfläche des Substrats 13 auf einer kleinen Querschnittsfläche stark n-dotiert, um eine Kontaktzone 25 zu bilden, die in leitendem Kontakt mit einer auf der Substratoberfläche abgeschiedenen Metallisierung 24 steht. Auf dem überwiegenden Teil ihres Querschnitts ist die Abschirmdotierungszone schwach n-dotiert, wie durch die lockere Schraffur angedeutet, mit einer geringeren Dotierungskonzentration als in den ebenfalls n-dotierten Emitterdotierungszonen. Wie der Querschnitt der Fig. 8 zeigt, verlängert sich durch die Abschirmdotierungszone 23 erheblich der Stromweg von den Emitterdotierungszonen 15 bis 18 zu benachbarten Elementen der (in Fig. 7 nicht gezeigten) Schaltungsteile 1 oder 2. Die Wirkung der Abschirmung beruht hier auf einem über die Metallisierung 24 an die Abschirmdotierungszone 23 angelegten positiven Potential, das zur Ausbildung einer Sperrschicht am pn-Übergang zwischen der Abschirmdotierungszone 23 und dem Substrat 13 führt.

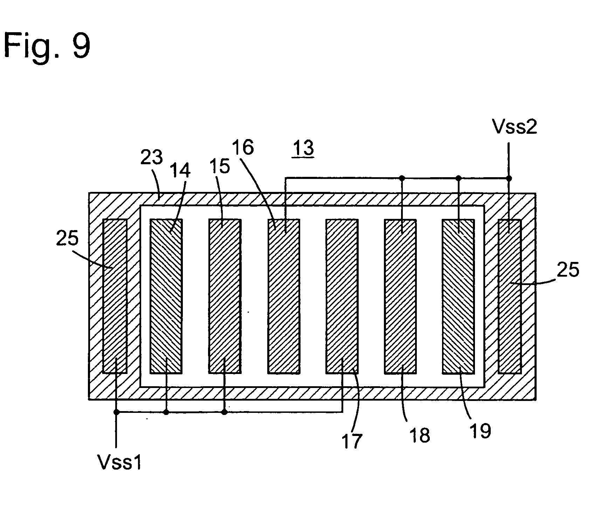

Fig. 9 zeigt ebenfalls eine weiterentwickelte Ausgestaltung des Layouts aus Fig. 6. Die Abschirmdotierungszone 23 umgibt ringförmig die Emitterdotierungszonen 15 bis 18. Im Gegensatz zur Ausgestaltung der Fig. 7 ist die Kontaktzone 25 nicht ringförmig um die Transistoren der Koppelschaltung herum angeordnet, sondern sie ist auf zwei Inseln beschränkt, die mit jeweils einem der zwei Potentiale Vss1, Vss2 leitend verbunden sind.

Da die Dotierungskonzentration in der Abschirmdotierungszone 23 niedrig gehalten werden kann, kann ihre Leitfähigkeit auf einem ähnlich niedrigen Wert wie die des Substrats 13 gehalten werden.

## Patentansprüche

1. Integrierte Schaltung mit wenigstens zwei Schaltungsteilen (1, 2), die auf einem Halbleitersubstrat (13) eines ersten Leitfähigkeitstyps gebildet sind und jeweils über eigene Versorgungsspannungsnetze verfügen, und wenigstens einer Koppelschaltung, die ein Potential eines ersten Versorgungsspannungsnetzes mit dem gleichen Potential (Vss1, Vss2; Vcc1, Vcc2) eines zweiten Versorgungsspannungsnetzes in Spannungsspitzen abfangender Weise verbindet, wobei die Koppelschaltung wenigstens einen Transistor (T1, T2, T3) mit einer Basis (20, 21, 22) vom ersten Leitfähigkeitstyp und Kollektor (15, 16, 17, 18) und Emitter (15, 16, 17, 18) eines zweiten Leitfähigkeitstyps umfasst, dessen Basis jeweils über einen Widerstand (R) mit einem Potential (Vss1, Vss2) des ersten Netzes und dem gleichen Potential des zweiten Netzes verbunden ist und dessen Kollektor direkt mit dem Potential des ersten Netzes und dessen Emitter direkt mit den gleichen Potential des zweiten Netzes verbunden ist.

2. Integrierte Schaltung nach Anspruch 1, **dadurch gekennzeichnet, dass** die Basis (20, 21, 22) des Transistors (T1, T2, T3) eine Region des Substrats (13) ist, und dass der Widerstand (R) der intrinsische Widerstand des Substrats (13) zwischen der Basis (20, 21, 22) und einer mit dem Kollektor bzw. Emitter metallisch verbundenen Kontaktdotierungszone (14, 19) ist.

3. Integrierte Schaltung nach Anspruch 1 oder 2, **dadurch gekennzeichnet, dass** Kollektor und Emitter des Transistors symmetrisch sind.

4. Integrierte Schaltung nach einem der vorhergehenden Ansprüche, **dadurch gekennzeichnet, dass** die Koppelschaltung eine Mehrzahl von parallel zwischen die Versorgungspotentiale (Vss1, Vss2) geschalteten Transistoren (T1, T2, T3) umfasst.

5. Integrierte Schaltung nach Anspruch 4, **dadurch gekennzeichnet, dass** die Transistoren eine Mehrzahl von Dotierungszonen (15, 16, 17, 18) des zweiten Leitfähigkeitstyps umfassen, die abwechselnd mit dem Potential des ersten Versorgungsspannungsnetzes (Vss1) und dem des zweiten Versorgungsspannungsnetzes (Vss2) verbunden sind.

6. Integrierte Schaltung nach Anspruch 5, **dadurch gekennzeichnet, dass** die Dotierungszonen (15, 16, 17, 18) in einer Reihe äquidistant angeordnet sind.

7. Integrierte Schaltung nach Anspruch 6, **dadurch gekennzeichnet, dass** die Dotierungszonen (15, 16, 17, 18) des zweiten Leitfähigkeitstyps quer zur Reihe langgestreckt sind.

8. Integrierte Schaltung nach Anspruch 2 und Anspruch 6 oder 7, **dadurch gekennzeichnet, dass** die Kontaktdotierungszonen (14, 19) an den Enden der Reihe angeordnet sind.

9. Integrierte Schaltung nach Anspruch 8, **dadurch gekennzeichnet, dass** in der Reihe jede Kontaktdotierungszone (14, 19) einer mit ihr metallisch verbundenen Dotierungszone (15, 18) des zweiten Leitfähigkeitstyps unmittelbar benachbart ist.

10. Integrierte Schaltung nach einem der Ansprüche 5 bis 9, **dadurch gekennzeichnet, dass** die Zahl der Dotierungszonen (15, 16, 17, 18) des zweiten Leitfähigkeitstyps gerade ist.

11. Integrierte Schaltung nach Anspruch 10, **dadurch gekennzeichnet, dass** sie vier Dotierungszonen (15, 16, 17, 18) des zweiten Leitfähigkeitstyps aufweist.

12. Integrierte Schaltung nach einem der vorhergehenden Ansprüche, **dadurch gekennzeichnet, dass** der wenigstens eine Transistor von einer Abschirmdotierungszone (23) des zweiten Leitfähigkeitstyps umgeben ist.

13. Integrierte Schaltung nach Anspruch 12, **dadurch gekennzeichnet, dass** die Abschirmdotierungszone (23) in Sperrrichtung vorgespannt ist.

14. Integrierte Schaltung nach Anspruch 12 oder 13, **dadurch gekennzeichnet, dass** die Abschirmdotierungszone (23) sich ringförmig entlang der Oberfläche des Substrats (13) erstreckt.

15. Integrierte Schaltung nach einem der Ansprüche 12 bis 14, **dadurch gekennzeichnet, dass** eine stark dotierte Kontaktzone (25) in der Abschirmdotierungszone (23) gebildet ist.

16. Integrierte Schaltung nach Anspruch 15, **dadurch gekennzeichnet, dass** die Kontaktzone (25) zwei Inseln umfasst, die jeweils mit einem der Potentiale (Vss1, Vss2) der zwei Netze leitend verbunden sind.

17. Integrierte Schaltung nach einem der Ansprüche 12 bis 15, **dadurch gekennzeichnet, dass** die Kontaktdotierungszonen (14, 19) auf der Abschirmdotierungszone (23) gebildet sind.

## Claims

1. Integrated circuit comprising at least two circuit parts (1, 2) which are formed on a semiconductor substrate (13) of a first conductivity type and which respectively have separate supply voltage networks, and comprising at least one coupling circuit which connects a potential of a first supply voltage network to the same potential (Vss1, Vss2; Vcc1, Vcc2) of a second supply voltage network so as to intercept voltage spikes, wherein the coupling circuit comprises at least one transistor (T1, T2, T3) with a base (20, 21, 22) of the first conductivity type and a collector (15, 16, 17, 18) and emitter (15, 16, 17, 18) of a second conductivity type, the base of which is connected in each case through a resistance (R) to a potential (Vss1, Vss2) of the first network and the same potential of the second network, and the collector of which is connected directly to the potential of the first network and the emitter of which is connected directly to the same potential of the second network.

2. Integrated circuit according to claim 1, **characterised in that** the base (20, 21, 22) of the transistor (T1, T2, T3) is a region of the substrate (13), and **in that** the resistance (R) is the intrinsic resistance of the substrate (13) between the base (20, 21, 22) and a contact doping zone (14, 19) metallically connected to the collector or emitter.

3. Integrated circuit according to claim 1 or 2, **characterised in that** the collector and emitter of the transistor are symmetrical.

4. Integrated circuit according to one of the preceding claims, **characterised in that** the coupling circuit comprises a plurality of transistors (T1, T2, T3) connected in parallel between the supply potentials (Vss1, Vss2).

5. Integrated circuit according to claim 4, **characterised in that** the transistors comprise a plurality of doping zones (15, 16, 17, 18) of the second conductivity type, which are alternately connected to the potential of the first supply voltage network (Vss1) and to that of the second supply voltage network (Vss2).

6. Integrated circuit according to claim 5, **characterised in that** the doping zones (15, 16, 17, 18) are arranged in one row at equal spacings from one another.

7. Integrated circuit according to claim 6, **characterised in that** the doping zones (15, 16, 17, 18) of the second conductivity type are of elongate shape transversely to the row.

8. Integrated circuit according to claim 2 and claim 6 or 7, **characterised in that** the contact doping zones (14, 19) are arranged at the ends of the row.

9. Integrated circuit according to claim 8, **characterised in that** each contact doping zone (14, 19) in the row is directly adjacent to a doping zone (15, 18) of the second conductivity type which is metallically connected thereto.

10. Integrated circuit according to one of claims 5 to 9, **characterised in that** the number of doping zones (15, 16, 17, 18) of the second conductivity type is even.

11. Integrated circuit according to claim 10, **characterised in that** it comprises four doping zones (15, 16, 17, 18) of the second conductivity type.

12. Integrated circuit according to one of the preceding claims, **characterised in that** the at least one transistor is surrounded by a shielding doping zone (23) of the second conductivity type.

13. Integrated circuit according to claim 12, **characterised in that** the shielding doping zone (23) is biased in the blocked direction.

14. Integrated circuit according to claim 12 or 13, **characterised in that** the shielding doping zone (23) extends annularly along the surface of the substrate (13).

15. Integrated circuit according to one of claims 12 to 14, **characterised in that** a highly doped contact zone (25) is formed in the shielding doping zone (23).

16. Integrated circuit according to claim 15, **characterised in that** the contact zone (25) comprises two islands which are each conductively connected to one of the potentials (Vss1, Vss2) of the two networks.

17. Integrated circuit according to one of claims 12 to 15, **characterised in that** the contact doping zones (14, 19) are formed on the shielding doping zone (23).

## Revendications

1. Circuit intégré ayant au moins deux parties de circuit (1, 2) réalisées sur un substrat semi-conducteur (13) d'un premier type de conductivité et ayant chacune son propre réseau de tension d'alimentation et au moins un circuit de couplage qui relie un potentiel d'un premier réseau d'alimentation au même potentiel (Vss1, Vss2; Vcc1, Vcc2) d'un second réseau d'alimentation en tension en écrêtant les pointes de tension, le circuit de couplage ayant au moins un transistor (T1, T2, T3) dont la base 20, 21, 22 est d'un premier type de conductivité et le collecteur (15, 16, 17, 18) et l'émetteur (15, 16, 17, 18) sont d'un second type de conductivité, la base des transistors étant reliée respectivement par l'intermédiaire d'une résistance (R) à un potentiel (Vss1, Vss2) du premier réseau et au même potentiel du second réseau, le collecteur des transistors étant relié directement au potentiel du premier réseau et l'émetteur des transistors étant relié directement au même potentiel du second réseau.

2. Circuit intégré selon la revendication 1,
**caractérisé en ce que**
la base (20, 21, 22) du transistor (T1, T2, T3) est une région du substrat (13), et
la résistance (R) est la résistance intrinsèque du substrat (13) entre la base (20, 21, 22) et une zone de dopage de contact (14, 19) reliée par une liaison métallique au collecteur ou à l'émetteur.

3. Circuit intégré selon la revendication 1 ou 2,
**caractérisé en ce que**
le collecteur et l'émetteur du transistor sont symétriques.

4. Circuit intégré selon les revendications précédentes,
**caractérisé en ce que**
le circuit de couplage comporte plusieurs transistors (T1, T2, T3) en parallèle entre les potentiels d'alimentation (Vss1, Vss2).

5. Circuit intégré selon la revendication 4,
**caractérisé en ce que**
les transistors comprennent plusieurs zones de dopage (15, 16, 17, 18) du second type de conductivité, reliés en alternance au potentiel du premier réseau de tension d'alimentation (Vss1) et à celui du second réseau d'alimentation en tension (Vss2).

6. Circuit intégré selon la revendication 5,
**caractérisé en ce que**
les zones de dopage (15, 16, 17, 18) sont installées en série de façon équidistante.

7. Circuit intégré selon la revendication 6,
**caractérisé en ce que**
les zones de dopage (15, 16, 17, 18) du second type de conductivité sont allongées transversalement à la série.

8. Circuit intégré selon les revendications 2 et 6 ou 7,
**caractérisé en ce que**
les zones de dopage de contact (14, 19) sont prévues à l'extrémité de la série.

9. Circuit intégré selon la revendication 8,
**caractérisé en ce que**
dans la série, chaque zone de dopage de contact (14, 19) est voisine d'une zone de dopage (15, 18) reliée mécaniquement à celle-ci et appartenant au second type de conductivité.

10. Circuit intégré selon les revendications 5 à 9,
**caractérisé en ce que**
le nombre de zones de dopage (15, 16, 17, 18) du second type de conductivité est un nombre pair.

11. Circuit intégré selon la revendication 10,
**caractérisé en ce qu'**
il comporte quatre zones de dopage (15, 16, 17, 18) du second type de conductivité.

12. Circuit intégré selon les revendications précédentes,
**caractérisé en ce qu'**
au moins un transistor est entouré par une zone de dopage formant écran (23) du second type de conductivité.

13. Circuit intégré selon la revendication 12,
**caractérisé en ce que**
la zone de dopage formant écran (23) est mise en tension de façon préalable dans le sens du blocage.

14. Circuit intégré selon la revendication 12 ou 13,
**caractérisé en ce que**
la zone de dopage formant écran (23) s'étend suivant une forme annulaire le long de la surface supérieure du substrat (13).

15. Circuit intégré selon les revendications 12 à 14,
**caractérisé par**
une zone de contact (25) fortement dopée réalisée dans la zone de dopage formant écran (23).

16. Circuit intégré selon la revendication 15,
**caractérisé en ce que**
la zone de contact (25) comprend deux îlots respectivement reliés à l'un des potentiels (Vss1, Vss2) du second réseau par une liaison conductrice.

17. Circuit intégré selon les revendications 12 à 15,
**caractérisé en ce que**
les zones de dopage de contact (14, 19) sont réalisées sur la zone de dopage formant écran (23).
